# EUROPEAN PATENT APPLICATION

(11) **EP 2 806 131 A1**
(43) Date of publication of application: **26.11.2014**
(21) Application number: 12865940.6
(22) Date of filing: 17.01.2012
(51) Int. Cl.: F01N 5/02, F01N 13/08, F25B 21/02

(54) **THERMOELECTRIC POWER GENERATING DEVICE**

(71) Applicant: TOYOTA JIDOSHA KABUSHIKI KAISHA, Toyota-shi, Aichi-ken, 471-8571 (JP)
(72) Inventor: IRIYAMA, Yojiro, Toyota-shi, Aichi-ken 471-8571 (JP)
(74) Representative: Kuhnen & Wacker
(86) International application number: PCT/JP2012/000239
(87) International publication number: WO 2013/108287

(57) **Abstract**

[Object] Provided is a thermoelectric power generating device that is able to detect an operating state of a thermoelectric conversion module with a simple configuration, thereby improving detection accuracy of the operating state of the thermoelectric conversion module. A thermoelectric power generating device (17) is configured to include: an inner pipe (21) including a bypass passage (25) into which exhaust gas discharged from an engine (1) is introduced; an outer pipe (23) provided coaxially with the inner pipe (21), forming with the inner pipe (21) a heat-receiving passage (22) into which the exhaust gas is introduced, and opposed to a heat-receiving substrate (29) of the thermoelectric conversion module (27); communicating holes (36) provided in the inner pipe (21) and communicating the bypass passage (25) with the heat-receiving passage (22); an opening/closing valve (26) provided in the inner pipe (21) so as to open and close the inner pipe (21); and an actuator (37) performing an opening/closing control on the opening/closing valve (26).

## Description

### TECHNICAL FIELD

The present invention relates to a thermoelectric power generating device, and particularly, relates to a thermoelectric power generating device configured to detect an operating state of a thermoelectric conversion module performing a thermoelectric power generation based on a temperature difference between a high-temperature part and a low-temperature part.

### BACKGROUND ART

Conventionally, a thermal energy is included in exhaust gas or the like discharged from an internal combustion engine of a vehicle such as an automobile, and if the exhaust gas is just discarded, the thermal energy is wasted. In view of this, the thermal energy included in the exhaust gas is collected by a thermoelectric power generating device, so as to be converted into an electrical energy and charged into a battery, for example.

As such a conventional thermoelectric power generating device, there has been known a thermoelectric power generating device in which a high-temperature part of a thermoelectric conversion module is opposed to an exhaust pipe into which exhaust gas discharged from an internal combustion engine is introduced, and a low-temperature part of the thermoelectric conversion module is opposed to a cooling water pipe through which cooling water circulates.

The thermoelectric conversion module is configured to include a thermoelectric transducer such as a semiconductor, electrodes, a heat-receiving substrate serving as the high-temperature part, a heat-dissipation substrate serving as the low-temperature part, and the like. The thermoelectric conversion module generates electric power by causing a temperature difference between the high-temperature part and the low-temperature part of the thermoelectric conversion module due to high-temperature exhaust gas and low-temperature cooling water by use of a Seebeck effect.

In the meantime, in the thermoelectric power generating device, when failure, deterioration, and the like of the thermoelectric conversion module occur, it becomes difficult to recover the electric power. In view of this, it is necessary to determine whether or not any failure occurs in the thermoelectric conversion module.

As a device for determining whether or not any failure occurs in the thermoelectric conversion module, there has been conventionally known a diagnostic device described in Patent Document 1 that performs diagnosis on a thermoelectric conversion module, for example.

The diagnostic device includes: measuring means for measuring an electric power generated in the thermoelectric conversion module; estimation means for estimating an electric power to be generated in the thermoelectric conversion module, by performing a predetermined computing based on signals indicative of respective measurement values measured by a temperature sensor, an air-intake sensor, an outdoor temperature sensor, and a vehicle speed sensor; and determination means for determining a normal range of electric power by adding, to the electric power thus estimated, an electric-power measurement error given to the measured electric power by a thermal resistance component.

In a case where the electric power thus measured is not included within the normal range of electric power, the diagnostic device gives a warning that the thermoelectric conversion module fails, via a display or an audio output portion.

### Citation List

### Patent Documents

Patent Document 1: Japanese Patent Application Publication No. 2008-223504

### SUMMARY OF THE INVENTION

### Problem to be Solved by the Invention

However, in such a conventional diagnostic device, the estimation means estimates the electric power to be generated in the thermoelectric conversion module, based on the signals indicative of respective measurement values measured by a plurality of sensors such as the temperature sensor, the air-intake sensor, the outdoor temperature sensor, and the vehicle speed sensor. Thus, the number of parameters used to estimate the electric power of the thermoelectric conversion module increases. On that account, a configuration of the diagnostic device becomes complicated, and in addition, a plurality of parameters are intertwined with each other and estimation accuracy becomes insufficient, which may cause a false determination.

The present invention is accomplished in order to solve the above conventional problem, and an object of the present invention is to provide a thermoelectric power generating device that is able to detect an operating state of a thermoelectric conversion module with a simple configuration, thereby improving detection accuracy of the operating state of the thermoelectric conversion module.

### Means for Solving the Problem

In order to achieve the above object, a thermoelectric power generating device according to the present invention is s thermoelectric power generating device including a thermoelectric conversion module performing a thermoelectric power generation according to a temperature difference between a high-temperature part and a low-temperature part, and the thermoelectric power generating device is configured to include: operating-state detection means for performing an operating-state detection process to detect an operating state of the thermoelectric conversion module based on a change of an electrical characteristic value of the thermoelectric conversion module at the time when a heating value to be transmitted to either one of the high-temperature part and the low-temperature part is changed.

In the thermoelectric power generating device, an electrical characteristic value output from the thermoelectric conversion module according to a heating value transmitted to the high-temperature part or the low-temperature part of the thermoelectric conversion module changes. In view of this, the operating-state detection means monitors the electrical characteristic value (for example, a voltage) output from the thermoelectric conversion module by changing the heating value transmitted to the high-temperature part or the low-temperature part of the thermoelectric conversion module, thereby detecting the operating state of the thermoelectric conversion module.

This makes it possible to simplify a configuration of the operating-state detection means and to highly accurately determine failure, deterioration, or the like of the thermoelectric conversion module based on the electrical characteristic value output from the thermoelectric conversion module.

Preferably, the high-temperature part may be provided to be opposed to an exhaust pipe into which exhaust gas discharged from an internal combustion engine is introduced; and the operating-state detection means may detect the operating state of the thermoelectric conversion module based on a change of the electrical characteristic value of the thermoelectric conversion module at the time when an exhaust-gas amount flowing through the exhaust pipe is changed.

In the thermoelectric power generating device, the operating-state detection means detects the operating state of the thermoelectric conversion module based on the change of the electrical characteristic value of the thermoelectric conversion module at the time when the exhaust-gas amount discharged from the internal combustion engine is changed. Accordingly, in a case where the thermoelectric power generating device is applied to a vehicle, it is possible to simplify the configuration of the operating-state detection means and to highly accurately determine failure, deterioration, or the like of the thermoelectric conversion module based on the electrical characteristic value output from the thermoelectric conversion module.

Preferably, the exhaust pipe may be configured to include a first exhaust pipe including a bypass passage into which the exhaust gas discharged from the internal combustion engine is introduced, a second exhaust pipe provided coaxially with the first exhaust pipe, forming with the first exhaust pipe a heat-receiving passage into which the exhaust gas is introduced, and opposed to the high-temperature part of the thermoelectric conversion module, and a communication portion communicating the bypass passage with the heat-receiving passage; an opening/closing valve opening and closing the first exhaust pipe, and opening/closing control means for performing an opening/closing control on the opening/closing valve may be provided; and the operating-state detection means may drive the opening/closing control means to perform the opening/closing control on the opening/closing valve so as to switch an exhaust passage of the exhaust gas between the bypass passage and the heat-receiving passage, thereby changing an exhaust-gas amount flowing through the heat-receiving passage.

In the thermoelectric power generating device, when the operating-state detection means drives the opening/closing control means to open the opening/closing valve, for example, the exhaust gas discharged from the internal combustion engine is discharged outside via the bypass pipe, so that the exhaust gas is not introduced into the heat-receiving passage.

Further, for example, when the operating-state detection means drives the opening/closing control means to close the opening/closing valve, the exhaust gas discharged from the internal combustion engine is introduced into the heat-receiving passage via the communication portion, so that heat of the exhaust gas is transmitted to the high-temperature part of the thermoelectric power generating device.

The operating-state detection means switches the opening/closing valve from an open state to a closed state, for example, so as to change an exhaust-gas amount introduced into the heat-receiving passage, thereby changing the heating value transmitted to the thermoelectric power generating device. Hereby, when the operating-state detection means monitors the change of the electrical characteristic value of the thermoelectric conversion module, it is possible to detect the operating state of the thermoelectric conversion module.

Preferably, the operating-state detection means may detect the operating state of the thermoelectric conversion module based on a change of the electrical characteristic value of the thermoelectric conversion module after the opening/closing valve is switched from an open state to a closed state.

In the thermoelectric power generating device, when the opening/closing valve is switched from the open state to the closed state, the exhaust-gas amount introduced into the heat-receiving passage is changed. When no failure, deterioration, or the like of the thermoelectric conversion module occurs, a power generation amount of the thermoelectric conversion module increases due to heat of the exhaust gas transmitted to the thermoelectric conversion module, thereby resulting in that the electrical characteristic value of the thermoelectric conversion module increases.

Accordingly, in a case where the electrical characteristic value of the thermoelectric conversion module does not increase after the opening/closing valve is switched from the open state to the closed state, the operating-state detection means is able to detect occurrence of failure, deterioration, or the like of the thermoelectric conversion module.

Thus, the operating-state detection means switches the opening/closing valve from the open state to the closed state, so as to change the exhaust-gas amount introduced into the heat-receiving passage, thereby changing the heating value transmitted to the thermoelectric conversion module. At this time, the operating-state detection means monitors the change of the electrical characteristic value of the thermoelectric conversion module, thereby making it possible to detect the operating state of the thermoelectric conversion module.

Preferably, the operating-state detection means may compare, with a threshold, the electrical characteristic value of the thermoelectric conversion module after the opening/closing valve is switched from the open state to the closed state, and when the electrical characteristic value is less than the threshold, the operating-state detection means may determine that the thermoelectric conversion module malfunctions.

In the thermoelectric power generating device, if the thermoelectric conversion module operates normally after the opening/closing valve is switched from the open state to the closed state, the electrical characteristic value of the thermoelectric conversion module increases.

In view of this, the operating-state detection means compares, with the threshold, the electrical characteristic value of the thermoelectric conversion module after the opening/closing valve is switched from the open state to the closed state. When the electrical characteristic value is less than the threshold, the operating-state detection means is able to determine that the thermoelectric conversion module causes a malfunction such as failure, deterioration, or the like.

This accordingly makes it possible to simplify the configuration of the operating-state detection means and to highly accurately determine a malfunction of the thermoelectric conversion module based on the electrical characteristic value output from the thermoelectric conversion module.

Preferably, the operating-state detection means may compare, with a threshold, the electrical characteristic value of the thermoelectric conversion module after the opening/closing valve is switched from the open state to the closed state, and when the electrical characteristic value is the threshold or more, the operating-state detection means may determine that the thermoelectric conversion module operates normally.

In the thermoelectric power generating device, if the thermoelectric conversion module operates normally after the opening/closing valve is switched from the open state to the closed state, the electrical characteristic value of the thermoelectric conversion module increases.

In view of this, the operating-state detection means compares, with the threshold, the electrical characteristic value of the thermoelectric conversion module after the opening/closing valve is switched from the open state to the closed state. When the electrical characteristic value is the threshold or more, the operating-state detection means is able to determine that the thermoelectric conversion module operates normally.

This accordingly makes it possible to simplify the configuration of the operating-state detection means and to highly accurately determine a malfunction of the thermoelectric conversion module based on the electrical characteristic value output from the thermoelectric conversion module.

Preferably, the operating-state detection means may stop power generations except for that of the thermoelectric conversion module during an execution of the operating-state detection process, and may detect the operating state of the thermoelectric conversion module based on a change of a voltage value of a battery accumulating therein an electric power generated by the thermoelectric conversion module.

In the thermoelectric power generating device, the operating-state detection means stops power generations except for that of the thermoelectric conversion module during the execution of the operating-state detection process, so as to detect the operating state of the thermoelectric conversion module based on the change of the voltage value of the battery accumulating therein the electric power generated by the thermoelectric conversion module. Accordingly, by accumulating, in the battery, only the electric power from the thermoelectric conversion module, it is possible to surely detect the operating state of the thermoelectric conversion module based on the change of the electrical characteristic value of the battery.

Accordingly, it is possible to detect the operating state of the thermoelectric conversion module without the use of a plurality of sensors that is used in a conventional technique, thereby making it possible to simplify the configuration of the operating-state detection means.

Preferably, the operating-state detection means may perform the operating-state detection process with the provision that a temperature of the exhaust gas is a predetermined temperature or more. In the thermoelectric power generating device, when an exhaust-gas temperature is low, the heating value transmitted to the thermoelectric conversion module is low, so that the power generation amount of the thermoelectric conversion module decreases. In view of this, at the time of a high exhaust-gas temperature at which the power generation amount of the thermoelectric conversion module is large, the operating-state detection process is performed, thereby making it possible to improve detection accuracy of the operating state of the thermoelectric conversion module.

Preferably, the operating-state detection means may perform the operating-state detection process with the provision that a vehicle performs steady running.

In the thermoelectric power generating device, in a case where the vehicle does not perform steady running, for example, the vehicle is accelerated or decelerated, the voltage value of the battery varies largely and the voltage value of the battery is unstable. In view of this, at the time when the vehicle performs steady running in which the voltage value of the battery is stable, the operating-state detection process is performed, thereby making it possible to improve detection accuracy of the operating state of the thermoelectric conversion module.

Preferably, the low-temperature part may be provided so as to be opposed to a cooling water pipe through which cooling water for cooling off the internal combustion engine circulates; and the operating-state detection means may detect the operating state of the thermoelectric conversion module based on a change of the electrical characteristic value of the thermoelectric conversion module at the time when a cooling-water amount flowing through the cooling water pipe is changed.

In the thermoelectric power generating device, the operating-state detection means detects the operating state of the thermoelectric conversion module based on the change of the electrical characteristic value of the thermoelectric conversion module at the time when the cooling-water amount cooling off the internal combustion engine is changed. Accordingly, when the thermoelectric power generating device is applied to a vehicle, it is possible to simplify the configuration of the operating-state detection means and to highly accurately determine failure, deterioration, or the like of the thermoelectric conversion module based on the electrical characteristic value output from the thermoelectric conversion module.

### Advantageous Effects of Invention

According to the present invention, it is possible to provide a thermoelectric power generating device that is able to detect an operating state of a thermoelectric conversion module with a simple configuration, thereby improving detection accuracy of the operating state of the thermoelectric conversion module.

### BRIEF DESCRIPTION OF THE DRAWINGS

[FIG. 1] FIG. 1 is a view illustrating a first embodiment of a thermoelectric power generating device according to the present invention, and is a schematic configuration diagram of a vehicle including the thermoelectric power generating device.
[FIG. 2] FIG. 2 is a view illustrating the first embodiment of the thermoelectric power generating device according to the present invention, and is a sectional view of a side surface of the thermoelectric power generating device.
[FIG. 3] FIG. 3 is a view illustrating the first embodiment of the thermoelectric power generating device according to the present invention, and is a perspective view of a thermoelectric conversion module.
[FIG. 4] FIG. 4 is a view illustrating the first embodiment of the thermoelectric power generating device according to the present invention, and is a system configuration diagram of the vehicle.
[FIG. 5] FIG. 5 is a view illustrating the first embodiment of the thermoelectric power generating device according to the present invention, and is a view illustrating a flow chart of an operating-state detection program.
[FIG. 6] FIG. 6 is a view illustrating the first embodiment of the thermoelectric power generating device according to the present invention, and is a view illustrating a change of a voltage value of a battery during an execution of an operating-state detection process.
[FIG. 7] FIG. 7 is a view illustrating a second embodiment of the thermoelectric power generating device according to the present invention, and is a view illustrating a flow chart of an operating-state detection program.
[FIG. 8] FIG. 8 is a view illustrating the second embodiment of the thermoelectric power generating device according to the present invention, and is a view illustrating a change of a voltage value of a battery during an execution of an operating-state detection process.
[FIG. 9] FIG. 9 is a view illustrating the first and second embodiments of the thermoelectric power generating device according to the present invention, and is a schematic configuration diagram of a vehicle including a thermoelectric power generating device having a different cooling water supply passage.

### MODES FOR CARRYING OUT THE INVENTION

Embodiments of a thermoelectric power generating device according to the present invention will be described below with reference to the drawings. Note that the present embodiments deal with a case where the thermoelectric power generating device is applied to a water-cooled multi-cylinder internal combustion engine to be provided in a vehicle such as an automobile, for example, a four-cycle gasoline engine (hereinafter just referred to as an engine). Further, the engine is not limited to the gasoline engine.

### (First Embodiment)

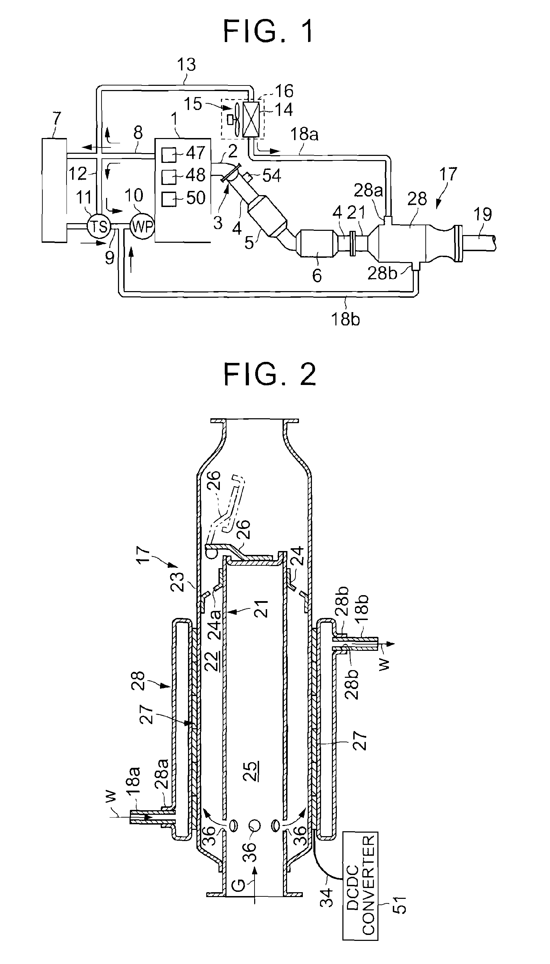

FIGS. 1 to 6 are views illustrating a first embodiment of the thermoelectric power generating device according to the present invention. First of all, a configuration thereof is described. As illustrated in FIG. 1, an engine 1 as an internal combustion engine provided in a vehicle such as an automobile is configured such that an air-fuel mixture obtained by mixing, at an appropriate air-fuel ratio, air supplied from an air-intake system and fuel supplied from a fuel supply system is supplied to a combustion chamber so as to be burnt, and then exhaust gas generated along with the burning is emitted from an exhaust system to the atmosphere.

The exhaust system is configured to include an exhaust manifold 2 attached to the engine 1, and an exhaust pipe 4 connected to the exhaust manifold 2 via a spherical joint 3, and an exhaust passage is formed by the exhaust manifold 2 and the exhaust pipe 4.

The spherical joint 3 allows the exhaust manifold 2 and the exhaust pipe 4 to swing moderately, and functions not to transmit a vibration or a movement of the engine 1 to the exhaust pipe 4 or functions to transmit the vibration or the movement by damping. Two catalysts 5, 6 are provided in series on the exhaust pipe 4, so that the exhaust gas is purified by the catalysts 5, 6.

In the catalysts 5, 6, the catalyst 5 provided on an upstream side in an exhaust direction of the exhaust gas within the exhaust pipe 4 is a so-called start catalyst (S/C), and the catalyst 6 provided on a downstream side in the exhaust direction of the exhaust gas within the exhaust pipe 4 is a so-called main catalyst (M/C) or underflow catalyst (U/F).

The catalysts 5, 6 are constituted, for example, by a three-way catalyst. The three-way catalyst demonstrates a purification interaction to collectively change carbon monoxide (CO), hydro carbon (HC), and nitrogen oxide (NOx) into a harmless component by a chemical reaction.

A water jacket is formed inside the engine 1, and the water jacket is filled with a coolant (hereinafter just referred to as cooling water) called long life coolant (LLC).

The cooling water is led out from a delivery pipe 8 attached to the engine 1 so as to be supplied to a radiator 7, and then returned from the radiator 7 to the engine 1 via a recirculation pipe 9 for the cooling water.

The radiator 7 cools off the cooling water circulated by a water pump 10 by heat exchange with external air.

Further, a bypass pipe 12 is connected to the recirculation pipe 9, and a thermostat 11 is placed between the bypass pipe 12 and the recirculation pipe 9. Hereby, a cooling water amount circulating through the radiator 7 and a cooling water amount circulating through the bypass pipe 12 are adjusted by the thermostat 11. For example, at the time of a warm-up operation of the engine 1, the cooling water amount of the bypass pipe 12 is increased so as to promote warm-up.

A heater pipe 13 is connected to the bypass pipe 12, and a heater core 14 is provided in the middle of the heater pipe 13. The heater core 14 is a heat source for heating a vehicle interior by use of heat of the cooling water.

The air warmed by the heater core 14 is introduced into the vehicle interior by a blower fan 15. Note that a heater unit 16 is constituted by the heater core 14 and the blower fan 15.

Further, a upstream pipe 18a for supplying the cooling water to the after-mentioned thermoelectric power generating device 17 is provided in the heater pipe 13, and a downstream pipe 18b for discharging the cooling water from the thermoelectric power generating device 17 to the recirculation pipe 9 is provided between the thermoelectric power generating device 17 and the recirculation pipe 9.

In view of this, in a case where an exhaust-heat recovery operation (details about the exhaust-heat recovery operation will be described later) is performed in the thermoelectric power generating device 17, a temperature of the cooling water flowing through the downstream pipe 18b is higher than a temperature of the cooling water flowing through the upstream pipe 18a.

In the meantime, the exhaust system of the engine 1 is provided with the thermoelectric power generating device 17. The thermoelectric power generating device 17 recovers heat of the exhaust gas discharged from the engine 1, and converts a thermal energy of the exhaust gas into an electrical energy.

As illustrated in FIG. 2, the thermoelectric power generating device 17 includes: an inner pipe 21 serving as an exhaust pipe into which the exhaust gas discharged from the engine 1 is introduced and as a first exhaust pipe; and an outer pipe 23 provided outside the inner pipe 21 and serving as an exhaust pipe forming a heat-receiving passage 22 with the inner pipe 21 and as a second exhaust pipe.

An upstream end of the inner pipe 21 is connected to the exhaust pipe 4, and a bypass passage 25 into which the exhaust gas is introduced from the exhaust pipe 4 is formed inside the inner pipe 21. The inner pipe 21 is fixed to an outer pipe 23 via a support member 24, and a downstream end of the outer pipe 23 is connected to a tail pipe 19.

Accordingly, exhaust gas G discharged from the engine 1 to the bypass passage 25 of the inner pipe 21 via the exhaust pipe 4 is discharged to the tail pipe 19 via the bypass passage 25, and then emitted to the external air from the tail pipe 19. Further, the thermoelectric power generating device 17 includes a plurality of thermoelectric conversion modules 27 and a tubular cooling water pipe 28.

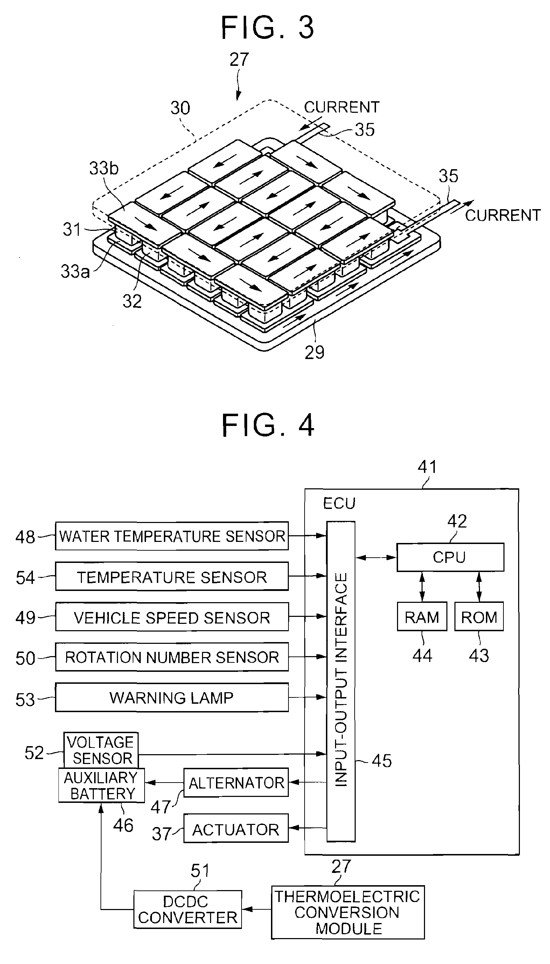

As illustrated in FIG. 3, the thermoelectric conversion module 27 is configured such that: a plurality of N-type thermoelectric transducers 31 and P-type thermoelectric transducers 32 generating an electromotive force according to a temperature difference due to the Seebeck effect is provided between a heat-receiving substrate 29 made from insulating ceramics and constituting a high-temperature part and a heat-dissipation substrate 30 made from insulating ceramics and constituting a low-temperature part; and the N-type thermoelectric transducers 31 and the P-type thermoelectric transducers 32 are provided alternately so as to be serially connected to each other via electrodes 33a, 33b. Further, the thermoelectric conversion modules 27 adjacent to each other are eclectically connected to each other via electric wirings 35.

The thermoelectric conversion module 27 is configured such that: the heat-receiving substrate 29 is opposed to the outer pipe 23 so as to make contact therewith; and the heat-dissipation substrate 30 is opposed to the cooling water pipe 28 so as to make contact therewith. A plurality of thermoelectric conversion modules 27 is provided in the exhaust direction of the exhaust gas G. Note that, in FIG. 1, the thermoelectric conversion module 27 illustrated in FIG. 3 is simplified.

The thermoelectric conversion module 27 performs a thermoelectric power generation according to a temperature difference between the heat-receiving substrate 29 and the heat-dissipation substrate 30, so as to supply an electric power to the after-mentioned auxiliary battery via a cable 34.

Note that the thermoelectric conversion module 27 is formed in a plate-like shape having a generally square shape, and it is necessary to make the thermoelectric conversion module 27 adhere between the outer pipe 23 and the cooling water pipe 28. In view of this, the outer pipe 23 and the cooling water pipe 28 are formed in a polygonal shape.

Alternatively, the outer pipe 23 and the cooling water pipe 28 may be formed in a round shape. In this case, the heat-receiving substrate 29, the heat-dissipation substrate 30, and so on of the thermoelectric conversion module 27 may be formed to be curved.

The cooling water pipe 28 includes a cooling-water inlet portion 28a connected to the upstream pipe 18a and a cooling-water outlet portion 28b connected to the downstream pipe 18b.

The cooling water pipe 28 is configured such that the cooling-water inlet portion 28a is provided on an upper side relative to the cooling-water outlet portion 28b in the exhaust direction upstream so that the cooling water W introduced into the cooling water pipe 28 from the cooling-water inlet portion 28a flows in the same direction as the exhaust direction of the exhaust gas G.

In the meantime, a plurality of communicating holes 36 as communication portions is formed in the inner pipe 21, and the communicating holes 36 communicate the bypass passage 25 with the heat-receiving passage 22. The communicating holes 36 are formed at regular intervals in a circumferential direction of the inner pipe 21. Note that the communicating holes 36 are not limited to those formed at regular intervals.

Further, in the support member 24, communicating holes 24a are formed at regular intervals over a circumferential direction of the support member 24, and the heat-receiving passage 22 communicates with the tail pipe 19 via the communicating holes 24a. Note that the communicating holes 24a are not limited to those formed at regular intervals.

Further, the inner pipe 21 is provided with an opening/closing valve 26. The opening/closing valve 26 is provided at a downstream end of the inner pipe 21, and is attached to the outer pipe 23 rotatably so as to open and close the inner pipe 21. The opening/closing valve 26 is opened and closed by an actuator 37 (see FIG. 4) as opening/closing control means.

As illustrated in FIG. 4, the actuator 37 is controlled by an ECU (Electronic Control Unit) 41, and the actuator 37 performs an opening/closing control on the opening/closing valve 26 based on an opening/closing signal from the ECU 41.

The ECU 41 is constituted by an electronic control circuit including a CPU (Central Processing Unit) 42, a ROM (Read Only Memory) 43, a RAM (Random Access Memory) 44, an input-output interface 45, and so on.

The CPU 42 detects an operating state of the thermoelectric conversion module 27 based on an operating-state diagnostic program stored in the ROM 43. The ROM 43 stores therein the operating-state diagnostic program, and the RAM 44 performs a temporary store of data, and constitutes a work area.

In the meantime, as illustrated in FIGS. 1, 4, the engine 1 is provided with an alternator 47 for charging the auxiliary battery 46 as a battery. The alternator 47 is driven by the engine 1 to perform a power generation so as to charge the auxiliary battery 46.

Further, the engine 1 is provided with a water temperature sensor 48. The water temperature sensor 48 detects a cooling-water temperature flowing in the engine 1, and outputs detected information to the ECU 41. Note that the water temperature sensor 48 may be provided in the heater pipe 13 or the like.

Further, the exhaust pipe 4 is provided with a temperature sensor 54. The temperature sensor 54 detects a temperature of the exhaust gas discharged to the exhaust pipe 4, and outputs detected information to the ECU 41.

Further, the vehicle is provided with a vehicle speed sensor 49. The vehicle speed sensor 49 is constituted by a wheel speed sensor for detecting a speed of wheel assemblies of the vehicle. The vehicle speed sensor 49 detects a wheel speed, and outputs a detection signal to the ECU 41.

The ECU 41 acquires a vehicle speed based on the detection signal from the vehicle speed sensor 49 and calculates an acceleration or a deceleration of the vehicle based on a change of the vehicle speed per unit time.

Further, the engine 1 is provided with a rotation number sensor 50. The rotation number sensor 50 detects, for example, the number of rotations of a crankshaft of the engine 1, and outputs, to the ECU 41, a signal according to an engine speed.

Further, the cable 34 of the thermoelectric conversion module 27 is connected to the auxiliary battery 46 via a DCDC converter 51. The DCDC converter 51 charges the auxiliary battery 46 in such a manner that a direct voltage output from the thermoelectric conversion module 27 is adjusted and applied to the auxiliary battery 46.

Further, the ECU 41 of the present embodiment performs the opening/closing control on the opening/closing valve 26 by driving the actuator 37 based on the engine speed output from the rotation number sensor 50.

More specifically, when the engine speed is within a low/middle rotation range, the ECU 41 transmits a closing signal to the actuator 37, so that the actuator 37 moves the opening/closing valve 26 to a close position as illustrated by a continuous line in FIG. 2, thereby closing the inner pipe 21. At this time, the exhaust gas introduced into the inner pipe 21 is introduced into the heat-receiving passage 22 via the communicating holes 36.

Further, when the engine speed is within a high rotation range, the ECU 41 transmits an opening signal to the actuator 37, so that the actuator 37 moves the opening/closing valve 26 to an opening position as illustrated by a broken line in FIG. 2, thereby opening the inner pipe 21. Hereby, the thermoelectric power generating device 17 is able to prevent a back pressure of the exhaust gas from increasing, thereby preventing an exhaust performance from decreasing.

Further, as illustrated in FIG. 4, the auxiliary battery 46 is provided with a voltage sensor 52, and the voltage sensor 52 detects a voltage of the auxiliary battery 46, and outputs, to the ECU 41, a detection signal corresponding to a voltage value of the auxiliary battery 46.

The ECU 41 performs an operating-state detection process to detect the operating state of the thermoelectric conversion module 27, based on a change of an electrical characteristic value of the auxiliary battery 46 at the time when an exhaust-gas amount transmitted to the heat-receiving substrate 29, that is, a heating value of the exhaust gas is changed. The ECU 41 constitutes operating-state detection means together with the voltage sensor 52.

When a malfunction of the thermoelectric conversion module 27 occurs, the ECU 41 outputs an abnormal signal to the warning lamp 53. When the warning lamp 53 receives the abnormal signal from the ECU 41, the warning lamp 53 gives a warning to a driver by lighting or flashing on and off. Note that, in the present embodiment, a voltage value of the auxiliary battery 46 constitutes the electrical characteristic value. Further, the warning lamp 53 may give a warning by sound of a buzzer or the like, audio, and the like.

Next will be described an interaction. At the time of cold start of the engine 1, the cooling water in the catalysts 5, 6 and the engine 1 is all at a low temperature (about an outdoor temperature).

When the engine 1 is started from this state, exhaust gas at a low temperature is discharged from the engine 1 to the exhaust pipe 4 via the exhaust manifold 2 along with the start of the engine 1, and temperatures of the two catalysts 5, 6 are increased by the exhaust gas.

Further, a warm-up operation is performed when the cooling water is returned to the engine 1 via the bypass pipe 12 without passing through the radiator 7.

At the time of cold starting of the engine 1, idling of the engine 1 is performed, for example, and a pressure of the exhaust gas is low. Accordingly, the ECU 41 outputs a closing signal to the actuator 37 so as to cause the opening/closing valve 26 to be closed.

Hereby, the exhaust gas introduced into the bypass passage 25 of the inner pipe 21 from the exhaust pipe 4 is introduced into the heat-receiving passage 22, so that a temperature of the cooling water circulating through the cooling water pipe 28 is increased by the exhaust gas passing through the heat-receiving passage 22, thereby promoting warm-up of the engine 1. Further, in the low/middle rotation range of the engine 1 after the warm-up of the engine 1, the ECU 41 outputs a closing signal to the actuator 37, so that the opening/closing valve 26 is closed.

At this time, the exhaust gas introduced into the bypass passage 25 of the inner pipe 21 from the exhaust pipe 4 is introduced into the heat-receiving passage 22, so that a thermal energy of the exhaust gas is efficiently converted into an electrical energy by the thermoelectric conversion module 27.

Further, in the high rotation range of the engine 1, it is necessary to increase a cooling performance of the engine 1. In the high rotation range of the engine 1, the ECU 41 outputs an opening signal to the actuator 37 so as to open the opening/closing valve 26.

When the opening/closing valve 26 is opened, the bypass passage 25 communicates with an inner side of the tail pipe 19, so that the exhaust gas hardly flows through the heat-receiving passage 22, thereby resulting in that the exhaust gas is directly discharged from the bypass passage 25 to the tail pipe 19. Because of this, the temperature of the cooling water circulating through the cooling water pipe 28 is not increased by the high-temperature exhaust gas. In addition to that, the thermoelectric conversion module 27 is not exposed to the high-temperature exhaust gas, so that the thermoelectric conversion module 27 does not receive heat damage. Accordingly, it is possible to prevent the thermoelectric conversion module 27 from being damaged.

At this time, the communication between the bypass pipe 12 and the recirculation pipe 9 is blocked by the thermostat 11, so that the cooling water led from the engine 1 via the delivery pipe 8 is led to the recirculation pipe 9 via the radiator 7. Accordingly, the cooling water at a low temperature is supplied to the engine 1, thereby increasing the cooling performance of the engine 1.

Further, since the opening/closing valve 26 is opened in the high rotation range of the engine 1, the back pressure of the exhaust gas flowing through the bypass passage 25 does not increase, thereby making it possible to prevent the exhaust performance of the exhaust gas from decreasing.

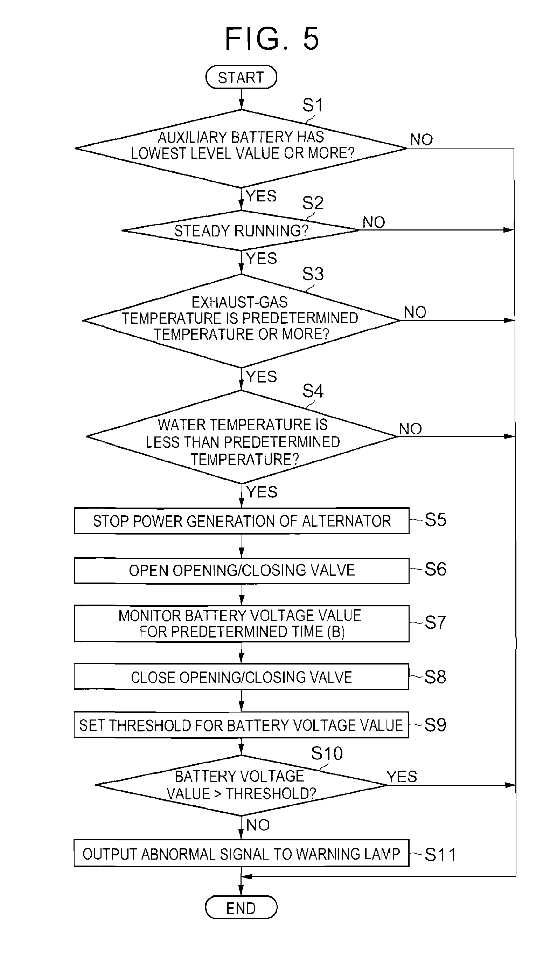

Next will be described an operating state diagnostic process of the thermoelectric conversion module 27 based on a flow chart illustrated in FIG. 5. Note that the flow chart of an operating-state diagnostic program illustrated in FIG. 5 is the operating-state diagnostic program stored in the ROM 43, and the operating-state diagnostic program is executed by the CPU 42. Further, the operating-state diagnostic program includes the operating-state detection process.

First, the CPU 42 determines, based on a detection signal from the voltage sensor 52, whether or not a voltage of the auxiliary battery 46 is a lowest level value or more (step S1). When it is determined that the voltage of the auxiliary battery 46 is less than the lowest level value, the CPU 42 determines that there is a high possibility that the auxiliary battery 46 has gone flat, and finishes the process at this time without performing the operating-state detection process. When it is determined that the voltage of the auxiliary battery 46 is the lowest level value or more, the CPU42 determines whether or not the vehicle performs steady running, based on detected information from the vehicle speed sensor 49 (step S2).

When it is determined that the vehicle is accelerated or decelerated, the CPU 42 determines that the voltage of the auxiliary battery 46 is unstable, and finishes the process at this time without performing the operating-state detection process. Further, when it is determined that the vehicle performs steady running, the CPU 42 determines that the voltage of the auxiliary battery 46 is stable, and then determines whether or not the temperature of the exhaust gas is a predetermined temperature or more, based on detected information from the temperature sensor 54 (step S3).

When it is determined that the temperature of the exhaust gas is less than the predetermined temperature, the CPU 42 finishes the process at this time without performing the operating-state detection process. That is, in a case where the temperature of the exhaust gas is low, the temperature of the exhaust gas to be transmitted to the heat-receiving substrate 29 of the thermoelectric power generating device 17 is low, that is, the heating value of the exhaust gas is small, and a power generation amount of the thermoelectric power generating device 17 is low.

When the power generation amount of the thermoelectric power generating device 17 is low, a voltage charged to the auxiliary battery 46 is low and a change of the voltage value of the auxiliary battery 46 is small. Accordingly, it is difficult to accurately determine the operating state of the thermoelectric conversion module 27 well, so that the CPU 42 does not perform the operating-state detection process on the thermoelectric conversion module 27.

When it is determined that the temperature of the exhaust gas is the predetermined temperature or more, the CPU42 determines whether or not a water temperature is less than a predetermined temperature, based on detected information from the water temperature sensor 48 (step S4).

When it is determined that the water temperature is the predetermined temperature or more, the CPU 42 determines that a cooling-water temperature supplied to the engine 1 is high and the engine 1 highly possibly causes overheat. Thus, the CPU 42 finishes the process at this time without performing the operating-state detection process.

In a case where the temperature of the cooling water is high, if the exhaust gas is introduced into the heat-receiving passage 22 and heat exchange between the cooling water and the exhaust gas is performed, the cooling-water temperature is further increased by the high-temperature exhaust gas. Accordingly, the CPU 42 outputs an opening signal to the actuator 37 so as to open the opening/closing valve 26, so that the exhaust gas is not introduced into the heat-receiving passage 22. At this time, cooling of the cooling water is performed as a priority, so as to perform a process to prevent overheat of the engine 1.

Further, when it is determined that the temperature of the cooling water is less than the predetermined temperature, the CPU 42 stops the power generation by the alternator 47 (step S5), and then outputs an opening signal to the actuator 37 so as to open the opening/closing valve 26 forcibly (step S6).

Because of this, the exhaust gas introduced into the inner pipe 21 from the exhaust pipe 4 is discharged to the tail pipe 19 via the inner pipe 21 without being introduced into the heat-receiving passage 22.

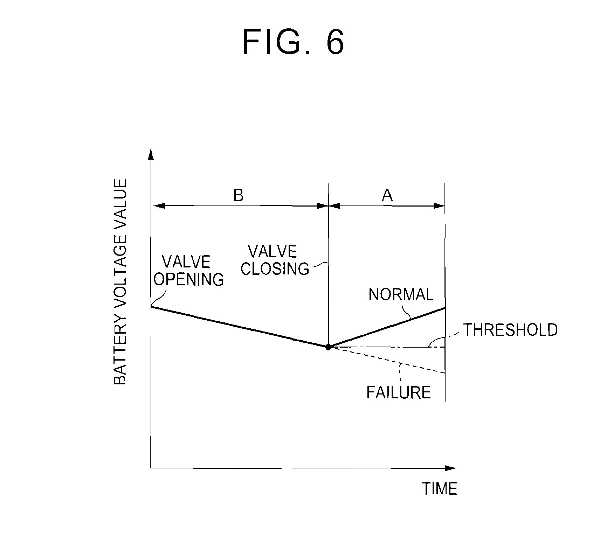

Subsequently, the CPU 42 monitors the voltage of the auxiliary battery 46 for a given time as indicated by B in FIG. 6 based on detected information from the voltage sensor 52 (step S7). Then, after the given time has elapsed, the CPU 42 outputs a closing signal to the actuator 37 so as to close the opening/closing valve 26 forcibly (step S8).

Thus, the exhaust gas introduced into the inner pipe 21 from the exhaust pipe 4 is introduced into the heat-receiving passage 22 via the communicating holes 36, and thus, the exhaust gas is transmitted to the heat-receiving substrate 29 of the thermoelectric conversion module 27. Hereby, a power generation is performed by the thermoelectric conversion module 27.

That is, the CPU 42 of the present embodiment switches a state where the opening/closing valve 26 is forcibly opened so as not to introduce the exhaust gas into the heat-receiving passage 22, to a state where the opening/closing valve 26 is forcibly closed so as to introduce the exhaust gas into the heat-receiving passage 22, thereby changing the exhaust-gas amount, that is, the heating value of the exhaust gas, to be transmitted to the heat-receiving substrate 29 of the thermoelectric conversion module 27,.

Subsequently, the CPU 42 stores, in the RAM 44, a voltage value of the battery at a time point when the opening/closing valve 26 is changed from an open state to a closed state, based on detected information from the voltage sensor 52, and sets this voltage value of the auxiliary battery 46 as a threshold (step S9).

After the opening/closing valve 26 is switched from the open state to the closed state, the CPU 42 determines whether or not that voltage value of the battery which is monitored based on the detection signal from the voltage sensor 52 is the threshold thus stored in the RAM 44 or more (step S10). This determination period is a given period indicated by A in FIG. 6, and during the given period, the voltage value of the battery is compared with the threshold stored in the RAM 44 several times.

When it is determined that the voltage value of the auxiliary battery 46 is the threshold or more, the CPU 42 determines that the thermoelectric conversion module 27 operates normally, and a charge state of the auxiliary battery 46 due to the power generation by the thermoelectric conversion module 27 is normal as shown by a continuous line in FIG. 6. Here, the process at this time is finished.

Further, when it is determined that the voltage value of the auxiliary battery 46 is less than the threshold, the CPU 42 determines that failure of the thermoelectric conversion module 27 due to disconnection of the cable 34 or the electric wirings 35, or a malfunction of the thermoelectric conversion module 27 due to deterioration or the like of the N-type thermoelectric transducers 31 or the P-type thermoelectric transducers 32 occurs, and the charge state of the auxiliary battery 46 due to the power generation by the thermoelectric conversion module 27 is abnormal as shown by a broken line in FIG. 6.

When it is determined that the thermoelectric conversion module 27 malfunctions, the CPU 42 outputs an abnormal signal to the warning lamp 53 (step S11), and the process at this time is finished. Note that, in the present embodiment, steps S5 to S11 correspond to the operating-state detection process.

Thus, the thermoelectric power generating device 17 of the present embodiment is configured to include: the inner pipe 21 including the bypass passage 25 into which the exhaust gas discharged from the engine 1 is introduced; the outer pipe 23 provided coaxially with the inner pipe 21, forming with the inner pipe 21 the heat-receiving passage 22 into which the exhaust gas is introduced, and opposed to the heat-receiving substrate 29 of the thermoelectric conversion module 27; the communicating holes 36 provided in the inner pipe 21 and communicating the bypass passage 25 with the heat-receiving passage 22; the opening/closing valve 26 provided in the outer pipe 23 so as to open and close the inner pipe 21; and the actuator 37 performing the opening/closing control on the opening/closing valve 26.

Then, the CPU 42 drives the actuator 37 to perform the opening/closing control on the opening/closing valve 26, so that an exhaust passage of the exhaust gas is changed between the bypass passage 25 and the heat-receiving passage 22, thereby changing an exhaust-gas amount flowing through the heat-receiving passage 22. This changes the heating value transmitted to the heat-receiving substrate 29 of the thermoelectric conversion module 27, and that voltage value of the auxiliary battery 46 which is output from the thermoelectric conversion module 27 is monitored, thereby detecting the operating state of the thermoelectric conversion module 27.

Hereby, it is possible to constitute the operating-state detection means from the ECU 41 and the voltage sensor 52. This makes it possible to simplify the operating-state detection means and to highly accurately determine failure, deterioration, or the like of the thermoelectric conversion module 27 based on the voltage value of the auxiliary battery 46.

Particularly, the CPU 42 of the present embodiment detects the operating state of the thermoelectric conversion module 27 based on the change of the voltage value of the auxiliary battery 46 after the opening/closing valve 26 is switched from the open state to the closed state. In view of this, when the voltage value of the auxiliary battery 46 does not increase after the opening/closing valve 26 is switched from the open state to the closed state, it is possible to detect occurrence of failure, deterioration, or the like of the thermoelectric conversion module 27.

Further, the CPU 42 of the present embodiment compares, with the threshold, the voltage value of the auxiliary battery 46 after the opening/closing valve 26 is switched from the open state to the closed state, and when the voltage value of the auxiliary battery 46 is less than the threshold, the CPU 42 determines that the thermoelectric conversion module 27 malfunctions.

Accordingly, by simplifying a configuration of the operating-state detection means, that is, by using the existing voltage sensor 52 in the auxiliary battery 46, it is possible to highly accurately determine a malfunction of the thermoelectric conversion module 27 based on the voltage value of the auxiliary battery 46.

Further, the ECU 41 of the present embodiment advances to step S5 with the provision that the vehicle performs steady running or the temperature of the exhaust gas is the predetermined temperature or more, and then, the ECU 41 performs the operating-state detection process from step S5 to step S11.

In view of this, at the time when the vehicle performs steady running in which the voltage of the auxiliary battery 46 is stable or at the time of a high exhaust-gas temperature at which a power generation amount of the thermoelectric conversion module 27 is large, the operating-state detection process is performed, thereby making it possible to improve detection accuracy of the operating state of the thermoelectric conversion module 27.

Further, the ECU 41 of the present embodiment stops the power generations except for the power generation of the thermoelectric conversion module 27 during the execution of the operating-state detection process, thereby detecting a change of a voltage value of the thermoelectric conversion module 27 based on the change of the voltage value of the auxiliary battery 46 that accumulates an electric power generated by the thermoelectric conversion module 27.

In view of this, by accumulating, in the auxiliary battery 46, only the electric power from the thermoelectric conversion module 27, it is possible to surely detect the operating state of the thermoelectric conversion module 27 based on the change of the electrical characteristic value of the auxiliary battery 46. Accordingly, it is possible to detect the operating state of the thermoelectric conversion module 27 without the use of a plurality of sensors that is used in a conventional technique, thereby making it possible to simplifying the configuration of the operating-state detection means.

Further, in the present embodiment, instead of the vehicle having only an internal combustion engine, in a case where the thermoelectric power generating device 17 is applied to a hybrid vehicle including an internal combustion engine and an electric motor and having a high-voltage battery accumulating therein an electric power from the electric motor, the process of step S5 is a process to stop charging to the auxiliary battery 46 from the high-voltage battery.

Note that the CPU 42 of the present embodiment sets, as the threshold, the voltage value of the battery at a time point when the opening/closing valve 26 is switched from the open state to the closed state, based on the detected information from the voltage sensor 52, and compares, with the threshold, the voltage value of the auxiliary battery 46. Then, when the voltage value of the auxiliary battery 46 is less than the threshold, the CPU 42 determines that the thermoelectric conversion module 27 malfunctions. However, the present invention is not limited to this.

For example, a map in which the voltage value of the auxiliary battery 46 is associated with a change of the voltage value of the auxiliary battery 46 after the opening/closing valve 26 is switched from the open state to the closed state at the time of a normal state of the thermoelectric conversion module 27 is formed, and the change of the voltage value may be taken as the threshold.

The CPU 42 compares, with the threshold, that voltage value of the auxiliary battery 46 which is input from the voltage sensor 52 after the opening/closing valve 26 is switched from the open state to the closed state. When the voltage value of the auxiliary battery 46 is less than the threshold, the CPU 42 can determine that the thermoelectric conversion module 27 malfunctions. Further, a map in which the voltage value of the auxiliary battery 46 is associated with a change of the voltage value of the auxiliary battery 46 after the opening/closing valve 26 is switched from the open state to the closed state at the time of a malfunction of the thermoelectric conversion module 27 is formed, and the change of the voltage value may be taken as the threshold.

The CPU 42 compares, with the threshold, that voltage value of the auxiliary battery 46 which is input from the voltage sensor 52 after the opening/closing valve 26 is switched from the open state to the closed state. When the voltage value of the auxiliary battery 46 is the threshold or more, the CPU 42 can determine that the thermoelectric conversion module 27 is normal. Further, in the present embodiment, the CPU 42 detects the operating state of the thermoelectric conversion module 27 based on the voltage value of the auxiliary battery 46. However, the CPU 42 may directly detect the voltage value of the thermoelectric conversion module 27.

That is, the CPU 42 sets a given threshold at a time point when the opening/closing valve 26 is switched from the open state to the closed state. When the voltage value of the thermoelectric conversion module 27 is the threshold or more, the CPU 42 determines that the thermoelectric conversion module 27 operates normally, and when the voltage value of the thermoelectric conversion module 27 is the threshold or less, the CPU 42 determines that the thermoelectric conversion module 27 malfunctions. The threshold in this case may be set to zero, for example.

Further, in the present embodiment, the threshold is compared with the voltage value of the auxiliary battery 46. However, the threshold may not be provided, and a malfunction of the thermoelectric conversion module 27 may be detected based on a change amount per unit time, that is, a rate of change, of the voltage value of the auxiliary battery 46 after the opening/closing valve 26 is switched from the open state to the closed state.

For example, the CPU 42 may detect, by a voltage sensor, a change of the voltage value of the thermoelectric conversion module 27 from a time point when the opening/closing valve 26 is switched from the open state to the closed state. When the voltage value of the thermoelectric conversion module 27 tends to increase, the CPU 42 may determine that the thermoelectric conversion module 27 operates normally. When the voltage value of the thermoelectric conversion module 27 tends to decrease, the CPU 42 may determine that the thermoelectric conversion module 27 malfunctions.

### (Second Embodiment)

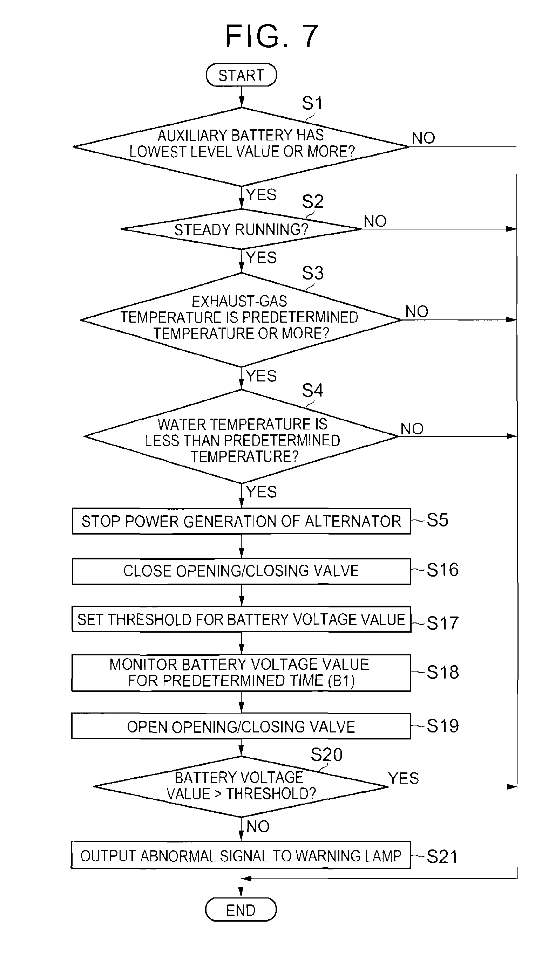

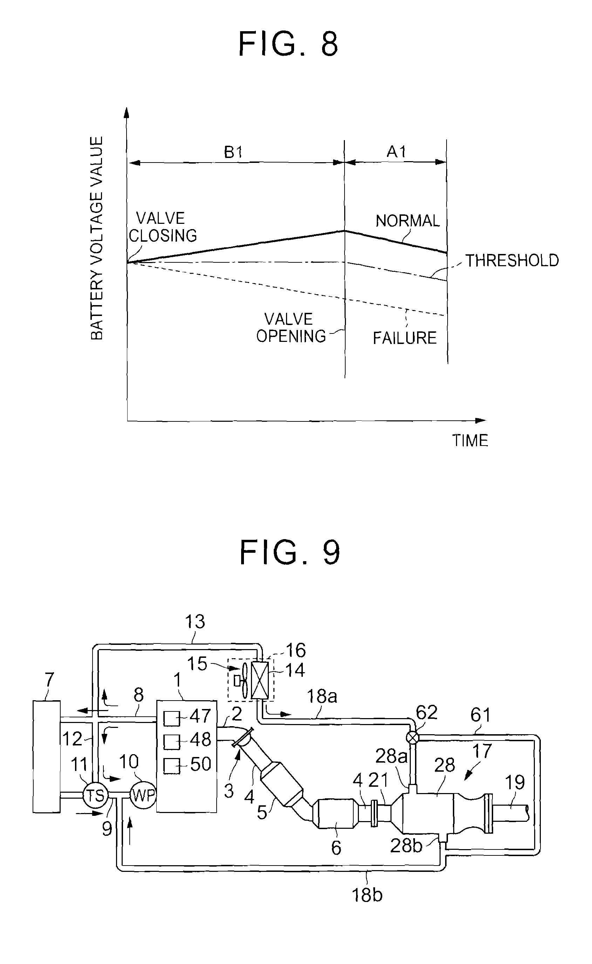

FIGS. 7, 8 are views illustrating a second embodiment of the thermoelectric power generating device according to the present invention. Its hard configuration is the same as the first embodiment, so that the hard configuration is described with reference to the drawings of the first embodiment.

The present embodiment has such a feature that a CPU 42 detects an operating state of a thermoelectric conversion module 27 based on a change of a voltage value of an auxiliary battery 46 after an opening/closing valve 26 is switched from a closed state to an open state.

After the CPU 42 stops a power generation by an alternator 47 in step S5 in FIG. 7, the CPU 42 outputs a closing signal to an actuator 37 so as to close the opening/closing valve 26 (step S16).

At this time, exhaust gas introduced into an inner pipe 21 from an exhaust pipe 4 is introduced into a heat-receiving passage 22 via communicating holes 36, so that a heating value of the exhaust gas to be transmitted to a heat-dissipation substrate 30 of a thermoelectric conversion module 27 increases.

Subsequently, the CPU 42 stores, in a RAM 44, a voltage value of a battery at a time point when the opening/closing valve 26 is switched from the open state to the closed state, and sets a threshold based on the voltage value of an auxiliary battery 46 (step S17).

Subsequently, the CPU 42 monitors a voltage of the auxiliary battery 46 for a given time as indicated by B1 in FIG. 8 based on detected information from a voltage sensor 52 (step S18). Then, after the given time has elapsed, the CPU 42 outputs an opening signal to the actuator 37 so as to open the opening/closing valve 26 forcibly (step S19). Because of this, the exhaust gas introduced into the inner pipe 21 from the exhaust pipe 4 is discharged to a tail pipe 19 from the inner pipe 21 without being introduced into the heat-receiving passage 22.

The CPU 42 determines whether or not the monitored voltage value of the battery is the threshold stored in the RAM 44 or more (step S20). This determination period is a given period indicated by A1 in FIG. 8, and during the given period A, the voltage value of the battery is compared with the threshold stored in the RAM 44 several times.

Here, in a case where the thermoelectric conversion module 27 operates normally, the voltage value of the auxiliary battery 46 increases as shown by a continuous line during B1 in FIG. 8, and the voltage value of the auxiliary battery 46 decreases during A1.

The CPU 42 compares the voltage value of the battery with the threshold stored in the RAM 44 during A1 in step S20, and when it is determined that the voltage value of the battery is the threshold or more, the CPU 42 determines that the thermoelectric conversion module 27 is normal, and the process at this time is finished.

Further, in a case where the thermoelectric conversion module 27 fails or deteriorates, the voltage value of the auxiliary battery 46 decreases as shown by a broken line during B1 in FIG. 8, and the voltage value of the auxiliary battery 46 further decreases during A1.

The CPU 42 compares the voltage value of the battery with the threshold stored in the RAM 44 during A1 in step S20, and when the voltage value of the battery is less than the threshold, the CPU 42 determines that the thermoelectric conversion module 27 malfunctions, and outputs an abnormal signal to a warning lamp 53 (step S21). Here, the process at this time is finished.

Thus, the CPU 42 of the present embodiment detects the operating state of the thermoelectric conversion module 27 based on the change of the voltage value of the auxiliary battery 46 after the opening/closing valve 26 is switched from the closed state to the open state. Accordingly, in a case where the voltage value of the auxiliary battery 46 does not increase after the opening/closing valve 26 is switched from the closed state to the open state, it is possible to detect occurrence of failure, deterioration, or the like of the thermoelectric conversion module 27.

Note that the thermoelectric power generating device 17 of each of the embodiments changes the heating value of the exhaust gas to be transmitted to the heat-receiving substrate 29 of the thermoelectric power generating device 17 by switching an exhaust-gas passage between the bypass passage 25 and the heat-receiving passage 22. However, the present invention is not limited to this.

For example, the inner pipe 21 and the opening/closing valve 26 may not be provided, so as to introduce the exhaust gas into the outer pipe 23. Then, a temperature of the exhaust gas introduced into the outer pipe 23 may be decreased by performing so-called fuel cut in which fuel to be supplied to cylinders of the engine 1 is cut, so as to change the heating value of the exhaust gas between burning of the fuel and the fuel cut.

Further, in each of the above embodiments, the operating-state detection process is performed by changing the heating value of the exhaust gas. However, the present invention is not limited to this. For example, the operating-state detection process may be performed by changing a cooling water amount to be transmitted to the heat-dissipation substrate 30 serving as the low-temperature part.

In this case, as illustrated in FIG. 9, a bypass pipe 61 communicating an upstream pipe 18a and a downstream pipe 18b, and a selector valve 62 provided in the upstream pipe 18a so as to switch a cooling-water flowing passage between the downstream pipe 18b and the bypass pipe 61 are provided.

Then, the CPU 42 outputs a switching signal to the selector valve 62 so as to switch a supply passage of the cooling water between the cooling water pipe 28 and the downstream pipe 18b, thereby detecting the operating state of the thermoelectric conversion module 27 based on a change of an electrical characteristic value of the thermoelectric conversion module at the time when the cooling water amount, that is, a heating value of the cooling water, to be transmitted to the heat-dissipation substrate 30 of the thermoelectric conversion module 27 is changed.

Even in this case, it is possible to simplify the operating-state detection means and to highly accurately determine failure, deterioration, or the like of the thermoelectric conversion module 27 based on the voltage value of the auxiliary battery 46.

Further, in each of the above embodiments, the voltage value of the auxiliary battery 46 is detected as the electrical characteristic value by the voltage sensor 52. However, a sensor for detecting a current or an electric power of the auxiliary battery 46 may be provided so as to detect a current value or an electric power value as the electrical characteristic value.

As described above, the thermoelectric power generating device according to the present invention is able to detect an operating state of a thermoelectric conversion module with a simple configuration, thereby yielding such an effect that detection accuracy of the operating state of the thermoelectric conversion module is improved. Thus, the thermoelectric power generating device according to the present invention is useful as a thermoelectric power generating device and the like configured to detect an operating state of a thermoelectric conversion module performing a thermoelectric power generation based on a temperature difference between a high-temperature part and a low-temperature part.

### Description of the Reference Numerals

1 engine (internal combustion engine)
17 thermoelectric power generating device
21 inner pipe (exhaust pipe, first exhaust pipe)
22 heat-receiving passage
23 outer pipe (exhaust pipe, second exhaust pipe)
25 bypass passage
26 opening/closing valve
27 thermoelectric conversion module
28 cooling water pipe
29 heat-receiving substrate (high-temperature part)
30 heat-dissipation substrate (low-temperature part)
36 communicating hole (communication portion)
37 actuator (opening/closing control means)
41 ECU (operating-state detection means)
46 auxiliary battery (battery)
52 voltage sensor (operating-state detection means)

## Claims

1. A thermoelectric power generating device including a thermoelectric conversion module performing a thermoelectric power generation according to a temperature difference between a high-temperature part and a low-temperature part, the thermoelectric power generating device **characterized by** comprising:
operating-state detection means for performing an operating-state detection process to detect an operating state of the thermoelectric conversion module based on a change of an electrical characteristic value of the thermoelectric conversion module at the time when a heating value to be transmitted to either one of the high-temperature part and the low-temperature part is changed.

2. The thermoelectric power generating device according to claim 1, **characterized in that**:
the high-temperature part is provided to be opposed to an exhaust pipe into which exhaust gas discharged from an internal combustion engine is introduced; and
the operating-state detection means detects the operating state of the thermoelectric conversion module based on a change of the electrical characteristic value of the thermoelectric conversion module at the time when an exhaust-gas amount flowing through the exhaust pipe is changed.

3. The thermoelectric power generating device according to claim 2, **characterized in that**:
the exhaust pipe is configured to include a first exhaust pipe including a bypass passage into which the exhaust gas discharged from the internal combustion engine is introduced, a second exhaust pipe provided coaxially with the first exhaust pipe, forming with the first exhaust pipe a heat-receiving passage into which the exhaust gas is introduced, and opposed to the high-temperature part of the thermoelectric conversion module, and a communication portion communicating the bypass passage with the heat-receiving passage;
an opening/closing valve opening and closing the first exhaust pipe, and opening/closing control means for performing an opening/closing control on the opening/closing valve are provided; and
the operating-state detection means drives the opening/closing control means to perform the opening/closing control on the opening/closing valve so as to switch an exhaust passage of the exhaust gas between the bypass passage and the heat-receiving passage, thereby changing an exhaust-gas amount flowing through the heat-receiving passage.

4. The thermoelectric power generating device according to claim 3, **characterized in that**:
the operating-state detection means detects the operating state of the thermoelectric conversion module based on a change of the electrical characteristic value of the thermoelectric conversion module after the opening/closing valve is switched from an open state to a closed state.

5. The thermoelectric power generating device according to claim 4, **characterized in that**:
the operating-state detection means compares, with a threshold, the electrical characteristic value of the thermoelectric conversion module after the opening/closing valve is switched from the open state to the closed state, and when the electrical characteristic value is less than the threshold, the operating-state detection means determines that the thermoelectric conversion module malfunctions.

6. The thermoelectric power generating device according to claim 4, **characterized in that**:
the operating-state detection means compares, with a threshold, the electrical characteristic value of the thermoelectric conversion module after the opening/closing valve is switched from the open state to the closed state, and when the electrical characteristic value is equal to or larger than the threshold, the operating-state detection means determines that the thermoelectric conversion module operates normally.

7. The thermoelectric power generating device according to any one of claims 1 to 6, **characterized in that**:
the operating-state detection means stops power generations except for that of the thermoelectric conversion module during an execution of the operating-state detection process, and detects the operating state of the thermoelectric conversion module based on a change of a voltage value of a battery accumulating therein an electric power generated by the thermoelectric conversion module.

8. The thermoelectric power generating device according to any one of claims 1 to 7, **characterized in that**:
the operating-state detection means performs the operating-state detection process when a temperature of the exhaust gas is equal to or higher than a predetermined temperature.

9. The thermoelectric power generating device according to claim 7, **characterized in that**:
the operating-state detection means performs the operating-state detection process when a vehicle performs steady running.

10. The thermoelectric power generating device according to claim 1, **characterized in that**:
the low-temperature part is provided so as to be opposed to a cooling water pipe through which cooling water for cooling off the internal combustion engine circulates; and
the operating-state detection means detects the operating state of the thermoelectric conversion module based on a change of the electrical characteristic value of the thermoelectric conversion module at the time when a cooling-water amount flowing through the cooling water pipe is changed.
